# EUROPÄISCHE PATENTANMELDUNG

(11) **EP 4 741 841 A1**
(43) Veröffentlichungstag der Anmeldung: **13.05.2026**
(21) Anmeldenummer: 25213244.4
(22) Anmeldetag: 04.11.2025
(51) Int. Cl.: G01R 19/25, G01R 31/40, G01R 35/00, H02M 1/00, G01D 18/00, G01R 19/00, G01R 19/165, H02M 7/12

(54) **VERFAHREN, KALIBRIER- UND MESS-VORRICHTUNG ZUR ERMITTLUNG EINES MESSWERTES**

(30) Priorität: 07.11.2024 AT 508812024
(71) Anmelder: AVL List GmbH, 8020 Graz (AT)
(72) Erfinder: Pumberger, Michael, 8041 Graz (AT); Matzer, Martin, 8200 Hofstätten an der Raab (AT)
(74) Vertreter: Patentanwälte Pinter & Weiss OG

(57) **Zusammenfassung**

Um Messfehler zu reduzieren, werden bei einem Aufbau umfassend einen Eingangs-Sensor (S₁) zum Messen einer Eingangsgröße (u₁) eines technischen Systems (2) sowie zum Ausgeben einer Eingangs-Sensorantwort (SA₁), eine Eingangs-Wandlungseinheit (W₁) zum Wandeln der Eingangs-Sensorantwort (SA₁) in einen Eingangs-Messwert (y₁), einen Ausgangs-Sensor (S₂) zum Messen einer Ausgangsgröße (u₂) des technischen Systems (2) sowie zum Ausgeben einer Ausgangs-Sensorantwort (SA₂) und eine Ausgangs-Wandlungseinheit (W₂) zum Wandeln der Ausgangs-Sensorantwort (SA₂) in einen Ausgangs-Messwert (y₂), in einem zeitlichen Kalibrier-Abschnitt, in dem sich das technische System (2) in einem Kalibrier-Zustand befindet, ein Eingangs-Messwert (y₁) und ein Ausgangs-Messwert (y₂) erfasst und miteinander verglichen, um einen Kalibrier-Vergleichswert (e_{y}) zu generieren, die Eingangs-Wandlungseinheit (W₁) in Abhängigkeit des Kalibrier-Vergleichswertes (e_{y}) zu einer korrigierten Eingangs-Wandlungseinheit (W₁) korrigiert, und in einem zeitlichen Aktiv-Abschnitt, in dem sich das technische System (2) in einem vom Kalibrier-Zustand verschiedenen Aktiv-Zustand befindet, die korrigierte Eingangs-Wandlungseinheit (W₁) dazu herangezogen, die Eingangsgröße (u₁) zu messen.

## Beschreibung

Die gegenständliche Erfindung betrifft ein Verfahren zur Ermittlung eines Messwertes, wobei ein Eingangs-Sensor zum messtechnischen Erfassen einer Eingangsgröße eines technischen Systems sowie zum Ausgeben einer Eingangs-Sensorantwort in Abhängigkeit der Eingangsgröße, eine Eingangs-Wandlungseinheit zum Wandeln der Eingangs-Sensorantwort in einen Eingangs-Messwert, ein Ausgangs-Sensor zum messtechnischen Erfassen einer Ausgangsgröße des technischen Systems sowie zum Ausgeben einer Ausgangs-Sensorantwort in Abhängigkeit der Ausgangsgröße, und eine Ausgangs-Wandlungseinheit zum Wandeln der Ausgangs-Sensorantwort in einen Ausgangs-Messwert vorgesehen werden. Ferner betrifft die Erfindung eine Kalibrier-Vorrichtung und eine Mess-Vorrichtung.

Stromrichteranordnungen sind in einer Vielzahl von Ausführungen bekannt und werden in einer Vielzahl verschiedener Anwendungen eingesetzt. Beispielsweise weisen Antriebe von Elektro- oder Hybridfahrzeugen Stromrichteranordnungen auf, um von Batterien zur Verfügung gestellte Gleichspannungen in geeignete Wechselspannungen umzuformen. Derart erzeugte Wechselspannungen werden in weiterer Folge an anzutreibende elektrische Maschinen angelegt. Stromrichteranordnungen umfassen typischerweise Kombinationen von Gleichrichtern (AC/DC-Wandler), Wechselrichtern (DC/AC-Wandler) und/oder Umrichtern (DC/DC-Wandler, AC/AC-Wandler, Hochsetzsteller, Tiefsetzsteller).

Zum Testen moderner Antriebskonzepte, die zumindest teilweise auf Elektromotoren basieren, werden typischerweise serielle Topologien aus Netzgleichrichtern (AC/DC-Wandler), Umrichtern (DC/DC-Wandlern) und Wechselrichtern (DC/AC-Wandler) eingesetzt. Ein Netzgleichrichter erzeugt dabei aus einer, in der Regel mehrphasigen, AC-Versorgungsspannung (Netz-Wechselspannung) zunächst eine DC-Zwischenkreisspannung, die mittels eines nachgeschalteten DC/DC-Wandlers (Hochsetzsteller, Tiefsetzsteller) auf ein geeignetes Spannungsniveau angepasst werden kann. Im Fall der Verwendung aktiver und damit schaltbarer Netzgleichrichter ("Synchrongleichrichter") kann auf einen separaten, nachgeschalteten DC/DC-Wandler auch verzichtet werden, und es kann unmittelbar vom Netzgleichrichter eine geregelte und demnach geeignet angepasste DC- Zwischenkreisspannung bereitgestellt werden. Eine so erzeugte Gleichspannung mit angepasstem Spannungsniveau kann mittels eines Wechselrichters in eine geeignete Wechselspannung gewandelt werden, wenn Wechselspannungen zum Testen erforderlich sind, beispielsweise in eine Wechselspannung je Phase eines zu testenden AC-Elektromotors. Auf diese Weise erhaltende Gleich- oder Wechselspannungen werden z.B. an die Statorwicklungen eines zu testenden Elektromotors angelegt, um einen benötigten Phasenstrom zum Generieren von Drehmomenten und/oder Drehzahlen zu bewirken. Entsprechende Strukturen sind aus dem Stand der Technik hinlänglich bekannt, z.B. aus AT 523580 B1 oder aus EP 2 855 193 B1.

In den genannten Anwendungsfällen mit seriellen Topologien aus Netzgleichrichtern und Wechsel- oder Umrichtern ist es erforderlich, eine DC-Zwischenkreisspannung präzise an einen vorgegebenen Sollwert einzuregeln, um einen zufriedenstellenden Betrieb eines nachgeschalteten Wechsel- oder Umrichters sicherstellen zu können, der die DC-Zwischenkreisspannung weiterverarbeitet. Zu diesem Zweck wird meist auf hochgenaue und hochauflösende Sensorik zum Messen der DC-Zwischenkreisspannung zurückgegriffen. Im angesprochenen Fall der Verwendung aktiver Netzgleichrichter zum Wandeln einer Netz-Wechselspannung in eine geregelte DC-Zwischenkreisspannung gelten vorstehende Ausführungen jedoch auch für das Messen der netzseitig am Netzgleichrichter anliegenden Netz-Wechselspannung. Wird eine Netz-Wechselspannung falsch gemessen, und wird einem Regler zum Regeln der DC-Zwischenkreisspannung und damit zum Schalten der Halbleiterschalter des Netzgleichrichters falsche Information über die Netz-Wechselspannung gegeben, ergeben sich in offensichtlicher Weise verschlechterte Regelungsperformance, Genauigkeitsverluste und mitunter sogar Stabilitätsprobleme. Man spricht von einer verminderten Qualität der "AC-seitigen Netzregelung".

Im vorstehend beschriebenen Szenario bereiten regelmäßig die Kalibrierung und Justierung von AC-Messketten zur AC-Messung Probleme. Bekanntermaßen müssen AC-Sensoren und entsprechende AC-Messketten in regelmäßigen Abschnitten kontrolliert und gegebenenfalls kalibriert und/oder justiert werden, beispielsweise bei der Inbetriebnahme, um Bauteilstreuungen auszugleichen, oder während des Betriebs, um Alterungseffekte und/oder Bauteildrift zu kompensieren. Kalibrierung und Korrektur von DC-Messketten sind typischerweise mit nur geringem Aufwand und ohne besondere technische Mittel möglich, sodass DC-Messketten für die Zwischenkreisspannung präzise eingestellt werden können, z.B. in Betriebspausen oder auch während des Betriebs, um die erforderlichen Genauigkeitsanforderungen zu erfüllen. Das trifft auf AC-Messketten zur Messung von netzseitigen Wechselspannungen jedoch nicht zu. Tatsächlich ist der Vorgang für die Kalibrierung bei Wechselgrößen deutlich aufwändiger als jener für die Kalibrierung bei Gleichgrößen. Das liegt einerseits daran, dass die zeitlichen Verläufe von Wechselgrößen komplexer sind (bei hohen Spannungen ergeben sich hohe Signalgradienten und hohe Signalamplituden), was komplexere Messketten zur Signalverarbeitung bedingt. Andererseits ist es insbesondere in Fällen mit großen elektrischen Leistungen schwierig, geeignete Vergleichssignale zu erzeugen, deren Signalparameter bekannt sind und die mit Messergebnissen von AC-Sensoren verglichen werden können. Es ergeben sich daher vielfach Situationen, wo die netzseitig an Netzgleichrichtern als Eingangsgrößen anliegenden Netz-Wechselspannungen falsch oder nur unzureichend gemessen werden.

Auch in anderen technischen Anwendungen mit anderen technischen Systemen, bei denen Ein- und Ausgangsgrößen präzise gemessen werden müssen, z.B. bei Prüfständen oder bei (Elektro-)Motoren oder bei Energiewandlern im Allgemeinen usw., treten im Zusammenhang mit sich zeitlich schnell ändernden Wechselgrößen vielfach unerwünschte Messfehler auf. Insbesondere wenn auf der Eingangsseite eines technischen Systems Wechselgrößen anliegen und auf der Ausgangsseite Gleichgrößen, treten nahezu unabhängig von der konkreten Ausgestaltung des technischen Systems vergleichbare Probleme beim Kalibrieren und Messen auf.

Es ist demnach eine Aufgabe der gegenständlichen Erfindung, Messfehler zu reduzieren.

Erfindungsgemäß wird diese Aufgabe für das eingangs genannte Verfahren und die eingangs genannte Kalibrier- und Mess-Vorrichtung gelöst, indem in einem zeitlichen Kalibrier-Abschnitt, in welchem sich das technische System in einem Kalibrier-Zustand befindet, ein Eingangs-Messwert und ein Ausgangs-Messwert erfasst und miteinander verglichen werden, vorzugsweise voneinander subtrahiert oder auf eine andere Art miteinander verglichen werden, um einen Kalibrier-Vergleichswert zu generieren, indem die Eingangs-Wandlungseinheit in Abhängigkeit des Kalibrier-Vergleichswertes zu einer korrigierten Eingangs-Wandlungseinheit korrigiert wird und/oder die Ausgangs-Wandlungseinheit in Abhängigkeit des Kalibrier-Vergleichswertes zu einer korrigierten Ausgangs-Wandlungseinheit korrigiert wird, und indem in einem zeitlichen Aktiv-Abschnitt, in dem sich das technische System in einem vom Kalibrier-Zustand verschiedenen Aktiv-Zustand befindet, die korrigierte Eingangs-Wandlungseinheit dazu herangezogen wird, die Eingangsgröße zu messen, und/oder die korrigierte Ausgangs-Wandlungseinheit dazu herangezogen wird, die Ausgangsgröße zu messen.

Durch die erfindungsgemäße Vorgehensweise wird eine Vielzahl von vorteilhaften Effekten realisiert und kombiniert. So wird es einerseits möglich, eine gegebenenfalls falsch eingestellte Eingangs-Wandlungseinheit zu korrigieren, ohne dass dafür ein aufwendiger Kalibrier- oder Justier-Aufbau vorgesehen werden muss. Wie aus dem Stand der Technik hinlänglich bekannt ist, werden Kalibrierversuche oftmals in eigens dafür vorgesehenen Kalibrierlabors durchgeführt, was in Szenarien, in denen die Erfindung angewandt werden kann, nicht mehr nötig ist, da hier auch in jenem Setting, in dem das gegebene technische System ohnehin eingesetzt wird, kalibriert werden kann. Darüber hinaus entfällt die Notwendigkeit, eigens für das Kalibrieren Vergleichssignale zu erzeugen und diese bereitzustellen. Insbesondere bei Sensoren und Wandlern zur Messung hoher Wechselspannungen ist die Bereitstellung realistischer Vergleichssignale vielfach mit erheblichen Schwierigkeiten verbunden, die im Rahmen der Erfindung ebenso nicht mehr erforderlich sind. Darüber hinaus ist es möglich, eine Kalibrierung wesentlich öfter durchzuführen, beispielsweise auch in Betriebspausen, was nicht möglich wäre, wenn die zu kalibrierenden Sensoren zu diesem Zweck eigens in ein Kalibrierlabor gebracht werden müssten. Die Messgenauigkeit und Zuverlässigkeit werden dadurch erhöht.

Es ist zu betonen, dass es die Erfindung ermöglicht, beide Wandlungseinheiten zu kalibrieren. Obwohl die Kalibrierung der Eingangs-Wandlungseinheit eine besonders vorteilhafte Realisierung der Erfindung darstellt, mit der insbesondere der eingangs genannte Fall einer fehlerhaften Wechselspannungsmessung bei einem Netzgleichrichter behandelt werden kann, ist genauso denkbar, lediglich die Ausgangs-Wandlungseinheit im Sinne der Erfindung zu korrigieren, was eine Anwendung der Erfindung in einer Vielzahl von weiteren Anwendungsfällen ermöglicht.

In der Praxis tritt häufig die Situation ein, dass die Wandlungseinheiten eine Wandlerverstärkung aufweisen, um eine entsprechende Sensorantwort in den Messwert zu wandeln. In diesem Fall kann die Erfindung besonders einfach umgesetzt werden, indem die Wandlerverstärkung zur Korrektur vergrößert oder verkleinert wird. Eine Wandlerverstärkung kann dabei insbesondere verstanden werden als ein multiplikativer Verstärkungsfaktor, der durch die Wandlungseinheit realisiert wird, zwischen der Sensorantwort und dem Messwert. Je nach Ausgestaltung kann durch die Erfindung in einer bevorzugten Weise einer Vergrößerung oder eine Verkleinerung der Wandlerverstärkung um bis zu 10% oder um bis zu 50% oder gar bis um zu 100% oder mehr eines aktuellen Wertes der Wandlerverstärkung erfolgen. Derartige Wandlungseinheiten können in Form einer analogen Wandlungseinheiten umgesetzt sein, wie insbesondere OPV-Schaltungen, z.B. als A/D-Wandler, wie Sigma-Delta-Umsetzer usw., oder die Wandlungseinheiten können auch als digitale Wandlungseinheiten umgesetzt sein, beispielsweise in Form eines digitalen Skalierungselement, das eine Sensorantwort auf einen vorgegebenen Bereich oder an ein vorgegebenes Format anpasst.

In vorteilhaften Ausgestaltungen der Erfindung können im Kalibrier-Abschnitt ein Eingangs-Messverlauf umfassend eine Vielzahl von Eingangs-Messwerten und ein Ausgangs-Messverlauf umfassend eine Vielzahl von Ausgangs-Messwerten erfasst und miteinander verglichen werden, um den Kalibrier-Vergleichswert zu generieren. Diese Vorgehensweise ermöglicht einerseits die Berücksichtigung einer größeren Zahl an Messwerten und damit die Berücksichtigung von mehr Information, anderseits aber auch die Anwendung moderner Filtermethoden zur Aufbereitung der Messwerte. Konkret kann hierzu der Eingangs-Messverlauf vor dem Vergleich mit dem Ausgangs-Messverlauf mittels eines Eingangs-Messfilters gefiltert werden und/oder der Ausgangs-Messverlauf vor dem Vergleich mit dem Eingangs-Messverlauf mittels eines Ausgangs-Messfilters gefiltert werden und/oder ein zeitlicher Verlauf von Kalibrier-Vergleichswerten vor einer Verwendung zur Korrektur der Eingangs-Wandlungseinheit mittels eines Vergleichs-Filters gefiltert werden. Das Eingangs-Messfilter und/oder das Ausgangs-Messfilter und/oder das Vergleichs-Filter können in Form eines Tiefpassfilters oder in Form eines Hochpassfilters oder in Form eines Bandpassfilters oder in Form eines Mittelwertfilters oder in Form eines Maximumfilters oder in Form eines Minimumfilters oder in Form einer Absolutwertbildung oder in Form eines Skalierungsfaktors oder in Form einer Kombination der vorgenannten Filter realisiert werden, beispielsweise um Messrauschen zu unterdrücken und/oder um systematische Störungen auszublenden, die sich z.B. aus Eigenheiten und/oder dynamischen Charakteristika des technischen Systems im Kalibrier-Zustand ergeben.

In einer weiteren vorteilhaften Ausgestaltung der Erfindung kann der Kalibrier-Vergleichswert zur Durchführung einer Plausibilitätsprüfung mit einem vorgegebenen Plausibilitätswert verglichen werden, beispielsweise ebenso durch Subtraktion oder durch eine andere Vergleichsmethode, und, wenn der Kalibrier-Vergleichswert den Plausibilitätswert überschreitet oder unterschreitet, eine Sicherungs-Aktion ausgelöst werden, wie ein Notaus oder eine sichere Abschaltfunktion oder eine Ausgabe einer Warnung. Auf diese Weise wird es überdies möglich, die Sicherheit eines technischen Systems zu erhöhen, bei welchem das erfindungsgemäße Verfahren eingesetzt wird.

Das erfindungsgemäße Verfahren kann insbesondere in einer Kalibrier-Vorrichtung umgesetzt werden, bei der es sich bevorzugt um geeignete Hardware handelt, die in der Lage ist, die erfindungsgemäßen Verfahrensschritte auszuführen. Eine solche Kalibrier-Vorrichtung kann ferner in einer besonders bevorzugten Weise als Teil einer Mess-Vorrichtung zur Ermittlung eines Messwertes vorgesehen werden.

Wie an früherer Stelle erläutert, stellen Netzgleichrichter ein besonders vorteilhaftes Anwendungsgebiet der gegenständlichen Erfindung dar, wobei der Netzgleichrichter insbesondere als Teil eines Batterieemulators oder als Teil eines Batterietesters vorgesehen sein kann. In derartigen Szenarien kann als Kalibrier-Zustand ein Zustand des Netzgleichrichters vorgesehen werden, in dem im Netzgleichrichter vorliegende Halbleiterschalter geöffnet sind und nicht geschaltet werden und es kann als Aktiv-Zustand ein Zustand des Netzgleichrichters vorgesehen werden, in welchem die im Netzgleichrichter vorliegenden Halbleiterschalter geschaltet werden, um eine vom Netzgleichrichter ausgegebene DC- Zwischenkreisspannung auf einen vorgegebenen Zwischenkreisspannungs-Sollwert einzuregeln. Im Rahmen dieser Ausgestaltung am Ausgang des schaltbaren Netzgleichrichters bevorzugt ein Zwischenkreiskondensator vorgesehen, an dem die DC-Zwischenkreisspannung abfällt, sodass es möglich wird, als zeitlichen Kalibrier-Abschnitt vorteilhaft einen Zeitabschnitt zu wählen, in welchem der Zwischenkreiskondensator geladen ist und nicht belastet wird.

Die gegenständliche Erfindung wird nachfolgend unter Bezugnahme auf die Figuren 1 bis 4 näher erläutert, die beispielhaft, schematisch und nicht einschränkend vorteilhafte Ausgestaltungen der Erfindung zeigen. Dabei zeigt
Fig.1 einen Batterieemulator nach dem Stand der Technik mit Netzgleichrichter,
Fig.2 einen erfindungsgemäßen Vergleich zweier Messketten,
Fig.3a-f bei Anwendung der Erfindung mögliche Signalverläufe,
Fig.4 eine Regelung eines Netzgleichrichters mithilfe des erfindungsgemäßen Verfahrens.

Die gegenständliche Erfindung wird nachfolgend anhand eines Batterieemulators 1 erläutert, wie er z.B. aus AT 517652 B1 oder aus WO 2013/174967 A1 bekannt ist. Es sei jedoch bereits an dieser Stelle darauf hingewiesen, dass die Erfindung nicht nur bei Batterieemulatoren 1 eingesetzt werden kann, sondern bei nahezu sämtlichen technischen Anwendungen, die auf einer Messung zweier physikalischer Größen basieren, die miteinander in Wirkverbindung stehender, und wo es gilt, hohe Genauigkeitsanforderungen einzuhalten.

Dementsprechend kann die Erfindung beispielsweise auch bei einem Elektromotor, z.B. einem Gleichstrommotor oder einem Synchronmotor oder einem Asynchronmotor, eingesetzt werden, in dessen Phasen ein Phasenstrom als Eingangsgröße eingeprägt wird und der ein Drehmoment als Ausgangsgröße erzeugt. Die Erfindung kann aber auch bei einem Verbrennungsmotor eingesetzt werden, wo eine Gaspedalstellung als Eingangsgröße vorgegeben wird und vom Verbrennungsmotor ein Kurbelwellendrehmoment als Ausgangsgröße erzeugt wird, oder die Erfindung kann auch bei ein Prüfständen verschiedenster Art eingesetzt werden, z.B. bei einem Antriebsstrangprüfstand, wo durch eine Belastungsmaschine ("Dynamometer") ein Belastungsdrehmoment als Eingangsgröße vorgegebenen wird und ein zu prüfender Prüfling mit einer Prüflingsdrehzahl als Ausgangsgröße auf das Belastungsdrehmoment reagiert. Batterieemulatoren 1 und/oder Batterietester und insbesondere Netzgleichrichter 2 für Batterieemulatoren 1 und/oder Batterietester stellen jedoch besonders geeignete Anwendungsfälle für die gegenständliche Erfindung dar, wie nachfolgend erläutert wird.

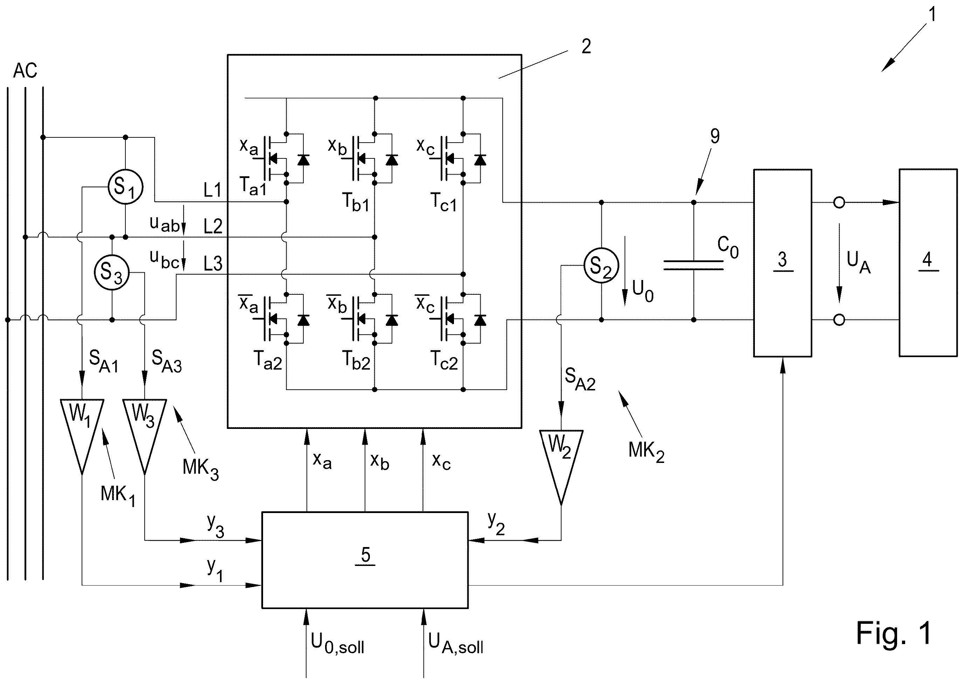

Der in Fig.1 gezeigte Batterieemulator 1 besteht aus einem eingangsseitigen Netzgleichrichter 2, der über einen Gleichspannungszwischenkreis 9 mit einer DC-Zwischenkreisspannung U₀ und einer Zwischenkreiskapazität C₀ mit einem Gleichspannungswandler 3 verbunden ist.

Der Netzgleichrichter 2 weist im gegenständlichen Fall die Halbleiterschalter Tₐ₁, Tₐ₂, T_{b1}, T_{b2}, T_{c1}, T_{c2} auf, die in einer bevorzugten Weise als IGBT-Schalter oder als SiC MOSFET-Schalter umgesetzt werden können, mit jeweils parallel zu den Halbleiterschaltern angeordneten Freilaufdioden. Wie später im Detail erläutert wird, wurde im Rahmen der Erfindung erkannt, dass ein schaltbarer Netzgleichrichter 2, wie jener aus Fig.1, zwei hinsichtlich seines Übertragungsverhaltens fundamentale Zustände annehmen kann, konkret einen ersten Zustand ("Kalibrier-Zustand"), in dem sämtliche Schalter geöffnet sind und nicht geschaltet werden, und einen zweiten Zustand ("Aktivitäts-Zustand"), in dem die Halbleiterschalter aktiv geschaltet werden.

Beim Gleichspannungswandler 3 kann es sich insbesondere um Hochsetzsteller oder Tiefsetzsteller handeln, mit denen ausgehend von der DC-Zwischenkreisspannung U₀ eine andere, sich gegebenenfalls langsam ändernde, Gleichspannung am Ausgang eingestellt werden kann, um das reale Verhalten einer Batterie auf einem Prüfstand nachzustellen, z.B. zur Versorgung eines als Last 4 vorgesehenen Elektromotors oder eines als Last 4 vorgesehenen Wechselrichters. Der Batterieemulator 1 wird von einem Wechselspannungsnetz AC mit einer netzseitigen AC-Spannung versorgt. Im gezeigten Fall eines in der Praxis typischerweise vorliegenden 3-Phasen-Netzes mit den Phasen L1, L2 und L3 fällt zwischen den Phasen L1 und L2 die netzseitige AC-Spannung u_{ab} ab, zwischen den Phasen L2 und L3 fällt die netzseitige AC-Spannung u_{bc} ab, und zwischen den Phasen L1 und L3 fällt die netzseitige AC-Spannung u_{ac} ab. Diese Zusammenhänge sind einer Fachperson auf dem Gebiet der Leistungselektronik hinlänglich bekannt.

Am Ausgang des Gleichspannungswandlers 3 ist eine Last 4 vorgesehen, z.B. ein auf einem Prüfstand zu testender Wechselrichter, die mit einer vom Gleichspannungswandler 3 bereitgestellten Ausgangsspannung u_{A} versorgt wird. Der Gleichspannungswandler 3 kann bekanntermaßen auch mehrphasig ausgeführt sein, und insbesondere als aktiv schaltbarer Synchronwandler mit einer Anzahl von Halbbrücken (je eine Halbbrücke pro Phase) mit Halbleiterschaltern implementiert werden.

Im Batterieemulator 1 ist weiters eine Steuereinheit 5 vorgesehen, die den Netzgleichrichter 2, d.h. die Schalter des Netzgleichrichters 2, und den Gleichspannungswandler 3, d.h. die Schalter des Gleichspannungswandlers 3, ansteuert, um eine gewünschte DC-Zwischenkreisspannung U₀ und/oder eine gewünschte Ausgangsspannung u_{Asoll} zu erzeugen, die z.B. von einer übergeordneten Steuereinheit angefordert werden. Die Steuereinheit 5 kann beispielsweise in Form von mikroprozessorbasierter Hardware, in Form eines Mikrocontrollers, oder in Form einer integrierten Schaltung (ASIC, FPGA) implementiert werden.

Typischerweise ist eine Pulsweitenmodulation PWM vorgesehen, um die Halbleiterschalter anzusteuern, was ebenso hinlänglich bekannt ist. Die Pulsweitenmodulation PWM kann direkt in der Steuereinheit 5 implementiert werden, wie in Fig.1 angenommen ist. Die Steuereinheit 5 erzeugt demnach aus den Sollwerten der Regelung, hier für die DC-Zwischenkreisspannung U_{0,soll} und für die Ausgangsspannung u_{Asoll}, Schaltsignale xₐ, x_{b}, x_{c} für die Halbleiterschalter Tₐ₁, Tₐ₂, T_{b1}, T_{b2}, T_{c1}, T_{c2} des Netzgleichrichters 2 sowie für die Halbleiterschalter des Gleichspannungswandlers 3. Eine PWM kann aber auch im Netzgleichrichter 2 selbst oder im Gleichspannungswandler 3 selbst implementiert werden, sodass eine Steuereinheit 5 lediglich entsprechende Steuersignale ausgeben müsste, z.B. einen gewünschten Duty-Cycle, und erst im Netzgleichrichter 2 oder erst im Gleichspannungswandler 3 aus einem Steuersignal Zündimpulse für die jeweiligen Halbleiterschalter ermittelt werden.

Zur praktischen Umsetzung einer Regelung müssen einem Regler in bekannter Weise Messdaten zur Verfügung gestellt werden, die Informationen über das zu regelnde System transportieren. Zur Regelung des gegenständlichen Netzgleichrichters 2 werden üblicherweise Messwerte der zwei netzseitigen AC-Spannungen u_{ab}, u_{bc} und Messwerte der DC-Zwischenkreisspannung U₀ benötigt (bei dem in Fig.1 angenommenen, symmetrischen dreiphasigen AC-Netzes reicht mitunter bereits eine AC-Spannung; typischerweise werden zwei AC-Spannungen gemessen und die dritte AC-Spannung aus den zwei gemessenen AC-Spannnung berechnet).

Vielfach wird zur Regelung eines Batterieemulators 1 oder eines Netzgleichrichters 2 auf PI-Regler oder auf PID-Regler oder auf Sliding-Mode-Regler oder auf Backstepping-Regler oder auf Konzepte der modellprädiktiven Regelung zurückgegriffen, die in einer Steuereinheit 5 implementiert werden und wo der Steuereinheit 5 neben den genannten Messwerten von u_{ab}, u_{bc}, U₀ überdies mathematische Modelle zur Verfügung gestellt werden, insbesondere Modelle des Netzgleichrichters 2 und/oder des Gleichrichters 3 und/oder der Last 4 usw.

Um die für die Regelung benötigten Messwerte der netzseitigen AC-Spannungen u_{ab}, u_{bc} und der DC-Zwischenkreisspannung U₀ bereitzustellen, sind im in Fig.1 gezeigten Fall mehrere Komponenten vorgesehen. So ist ein Eingangs-Sensor S₁ zum messtechnischen Erfassen der netzseitigen AC-Spannung u_{ab} vorgesehen. Der Eingangs-Sensor S₁ erzeugt dabei ein Eingangs-Sensorantwort SA₁ in Abhängigkeit der AC-Spannung u_{ab}, welche Eingangs-Sensorantwort SA₁ von einer ersten Eingangs-Wandlungseinheit W₁ in einen Eingangs-Messwert y₁ gewandelt wird und auf diese Weise der Steuereinheit 5 zugeführt wird. Ferner ist ein Ausgangs-Sensor S₂ vorgesehen, der die DC-Zwischenkreisspannung U₀ misst (diese entspricht einer Ausgangsgröße u₂ des Netzgleichrichters 2) und der eine Ausgangs-Sensorantwort SA₂ in Abhängigkeit der DC-Zwischenkreisspannung U₀ erzeugt. Eine Ausgangs-Wandlungseinheit W₂ wandelt die Ausgangs-Sensorantwort SA₂ in einen Ausgangs-Messwert y₂, welcher ebenso der Steuereinheit 5 zugeführt wird und dort zur Regelung verwendet werden kann. Der Eingangs-Sensor S₁ und die Eingangs-Wandlungseinheit W₁ bilden hierbei eine erste Messkette MK1, die im gezeigten Fall die Funktion einer Spannungsmesskette ("Voltmeter") ausübt. Der Ausgangs-Sensor S₂ und die Ausgangs-Wandlungseinheit W₂ bilden dementsprechend eine zweite Messkette MK2, die ebenso die Funktion einer Spannungsmesskette ausübt, also ebenso eines Voltmeters. Gleiche Ausführungen gelten für die dritte in Fig.1 dargestellte Messkette MK₃ umfassend einen dritten Sensor S3 und eine dritte Wandlungseinheit, welche die weitere netzseitige AC-Spannung u_{bc} misst. Eine solche dritte Messkette MK₃ ist in der der praktischen Umsetzung einer Regelung eines Netzgleichrichters 2 oder der Erfindung vorteilhaft, jedoch nicht zwingend nötig.

Wie eingangs erläutert, ergibt sich bei der Regelung von Netzgleichrichtern 2 oftmals das Problem, dass netzseitige Wechselspannungen u_{ab}, u_{bc} nicht mit ausreichender Präzision gemessen werden. Messungenauigkeiten einer AC-seitigen Spannungsmessung können die Qualität der Regelung eines Netzgleichrichters 2 empfindlich beeinträchtigen. Beispielsweise können falsche Informationen über netzseitig anliegende AC-Spannungen zu falschen Ansteuerzeiten der Halbleiterschalter Tₐ₁, Tₐ₂, T_{b1}, T_{b2}, T_{c1}, T_{c2} führen, die beispielsweise zu lange geöffnet bleiben, weil ein in der Steuereinheit 5 implementierter Regler aufgrund zu geringer Messwerte auf zu geringe Ströme schließt. In gravierenden Fällen kann es in solchen Szenarien sogar zu Beschädigungen der gezeigten Bauteile (Zwischenkreiskondensator C₀, Last 4, ...) kommen.

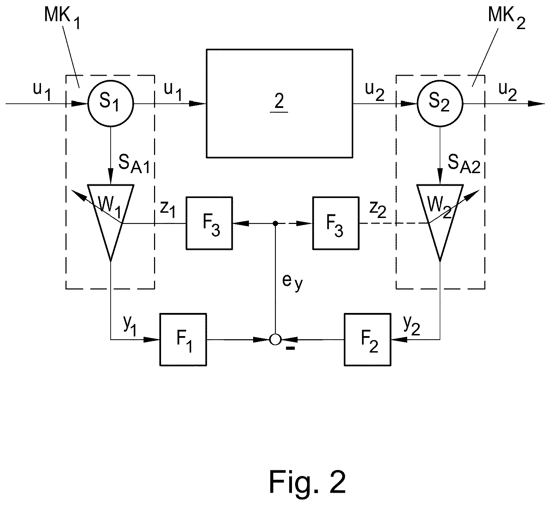

Unter anderem diese Probleme werden durch die gegenständliche Erfindung gelöst, bzw. zumindest gemindert. Die Erfindung sieht zu diesem Zweck einen Vergleich der genannten Messwerte y₁, y₂ vor. Da es sich beim gegenständlichen Batteriesimulator 1 zwar um eine bevorzugte Anwendung handelt, die Erfindung aber keineswegs auf Batteriesimulatoren 1 und/oder Netzgleichrichter 2 eingeschränkt ist, wird die erfindungsgemäße Vorgehensweise anhand von Fig.2 zunächst allgemein beschrieben. Hierzu wird anstelle des vorstehend betrachteten Netzgleichrichters 2 von einem allgemeinen technischen System 2 ausgegangen, über welches eine zu messende Eingangsgröße u₁ (z.B. eine netzseitige AC-Spannung u_{ab}) mit einer zu messenden Ausgangsgröße u₂ (z.B. eine DC-Zwischenkreisspannung U₀) in Zusammenhang steht.

Wie anhand von Fig.2 erkennbar ist, werden ein Eingangs-Messwert y₁ und ein Ausgangs-Messwert y₂, die jeweils mittels einer vorstehend beschriebenen Messkette MK₁, MK₂ aus Sensor S₁, S₂ und Wandler W₁, W₂ erfasst wurden, miteinander verglichen, vorzugsweise voneinander subtrahiert, wodurch ein Kalibrier-Vergleichswert e_{y} generiert wird. Es sei angemerkt, dass die Erfindung nicht auf die Verwendung einer Subtraktion zum Vergleichen beschränkt ist. So könnte zur Umsetzung der Erfindung auch lediglich überwacht werden, ob ein Messwert größer ist als ein anderer, oder ob sich die Messwerte um mehr als eine vorgegebene Schranke unterscheiden. Die Eingangs-Wandlungseinheit W₁ wird daraufhin in Abhängigkeit des Kalibrier-Vergleichswertes e_{y} zu einer korrigierten Eingangs-Wandlungseinheit W₁ korrigiert, und es wird in weiterer Folge die korrigierte Eingangs-Wandlungseinheit W₁ dazu herangezogen, die Eingangsgröße u₁ zu messen. Für das erfindungsgemäße Verfahren ist hierbei entscheidend, dass das Erfassen zumindest eines Eingangs-Messwertes y₁ sowie das Erfassens zumindest eines Ausgangs-Messwertes y₂ zum Vergleichen und das Vergleichen selbst in einem zeitlichen Kalibrier-Abschnitt stattfindet, in dem sich das technische System 2 in einem Kalibrier-Zustand befindet, und dass in einem dem zeitlichen Kalibrier-Abschnitt folgenden zeitlichen Aktiv-Abschnitt, in dem sich das technische System 2 in einem vom Kalibrier-Zustand verschiedenen Aktiv-Zustand befindet, mithilfe der korrigierten Eingangs-Wandlungseinheit W₁ gemessen wird, ohne aber eine weitere Veränderung oder Korrektur der Eingangs-Wandlungseinheit W₁ vorzunehmen. Auch die Korrektur der Wandlungseinheiten erfolgt bevorzugt im Kalibrier-Abschnitt, grundsätzlich ist aber auch eine Korrektur im Aktiv-Abschnitt denkbar. Eine Kalibrier-Vorrichtung, in der das erfindungsgemäße Verfahren zur Kalibrierung einer Eingangs-Wandlungseinheit umgesetzt ist, oder eine Mess-Vorrichtung, die eine solche Kalibrier-Vorrichtung umfasst, kann vorzugsweise dazu ausgestaltet sein, einen Kalibrier-Zustand oder einen Aktiv-Zustand selbst zu erkennen, beispielsweise durch geeignete Analyse der erfassten Messwerte, oder es kann eine Schnittstelle aufweisen, sodass der Kalibrier-Vorrichtung das Vorliegen eines entsprechenden Zustandes mitgeteilt werden kann, beispielsweise durch einen Bediener oder durch eine geeignete Steuereinheit.

Der vorstehend beschriebenen Vorgehensweise liegt die Einsicht zugrunde, dass es vielfach technische System gibt, deren Ein- und Ausgangsgrößen präzise gemessen werden müssen, und die zumindest zwei (System-)Zustände annehmen können, von denen sich ein erster Zustand mitunter hervorragend für eine Kalibrierung eignet, ein anderer Zustand jedoch für eine Kalibrierung nicht zugänglich ist. Dies ist insbesondere dann der Fall, wenn die Eingangsgröße u₁ gemäß einem durch den Zustand des technischen Systems 2 festgelegten Übertragungsverhältnis mit der Ausgangsgröße u₂ zusammenhängt, und das Übertragungsverhältnis im Kalibrier-Abschnitt einem vorgegebenen, gleichbleibenden Übertragungsverhältnis entspricht, und im Aktiv-Abschnitt einem veränderlichen, insbesondere nicht vorhersagbar veränderlichen, Übertragungsverhältnis entspricht. Der Kalibrier-Zustand, den das System im Kalibrier-Abschnitt annimmt, zeichnet sich folglich durch eine vorhersagbare, deterministische Übertragungscharakteristik aus, die gleichbleibt oder zumindest weitgehend gleichbleibt. Unter "Gleichbleiben" wäre unter idealen Voraussetzungen zu verstehen, dass sich eine Übertragungscharakteristik gar nicht ändert. Unter realen, in der Praxis vorliegenden Bedingungen kommt es bekanntermaßen aber stets zu geringfügigen Schwankungen, z.B. zu geringfügigen Schwankungen der Charakteristik von im technischen System 2 verbauten Bauteilen, wie von elektrischen Widerständen oder von anderen elektrischen Bauteilen oder von mechanischen Bauteilen. Eine Übertragungscharakteristik eines technischen Systems, wie eine Verstärkung eines technischen Systems, wird demnach im Rahmen der gegenständlichen Überlegungen als gleichbleibend erachtet, wenn sie sich im Betrieb lediglich in einem Maß ändert, das hervorgerufen ist durch geringe Bauteilschwankungen. Das bedeutet, dass eine Verstärkung beispielsweise um weniger als 1% oder um weniger als 0,1% oder um weniger als 0,01% schwankt. Im Fall eines Aktiv-Zustandes können bei einer Verstärkung hingegen nicht vorhersagbare Änderungen von mehr als 25% oder mehr 50% oder mehr als 75% der Verstärkung auftreten.

Durch die erfindungsgemäße Vorgehensweise wird eine Vielzahl von vorteilhaften Effekten realisiert und kombiniert. So wird es einerseits möglich, eine gegebenenfalls falsch eingestellte Eingangs-Wandlungseinheit W₁ zu korrigieren, ohne dass dafür ein aufwendiger Kalibrier- oder Justier-Aufbau vorgesehen werden muss. Wie aus dem Stand der Technik hinlänglich bekannt ist, werden Kalibrierversuche oftmals in eigens dafür vorgesehenen Kalibrierlabors durchgeführt, was in Szenarien, in denen die Erfindung angewandt werden kann, nicht mehr nötig ist, da hier auch in jenem Setting, in dem das gegebene technische System ohnehin eingesetzt wird, kalibriert werden kann. Darüber hinaus entfällt die Notwendigkeit, eigens für das Kalibrieren Vergleichssignale zu erzeugen und diese bereitzustellen. Insbesondere bei Sensoren und Wandlern zur Messung hoher Wechselspannungen ist die Bereitstellung realistischer Vergleichssignale vielfach mit erheblichen Schwierigkeiten verbunden, die im Rahmen der Erfindung ebenso nicht mehr erforderlich sind. Darüber hinaus ist es möglich, eine Kalibrierung wesentlich öfter durchzuführen, beispielsweise auch in Betriebspausen, was nicht möglich wäre, wenn die zu kalibrierenden Sensoren zu diesem Zweck eigens in ein Kalibrierlabor gebracht werden müssten. Die Messgenauigkeit und Zuverlässigkeit wird dadurch erhöht.

Weist die Eingangs-Wandlungseinheit W₁ eine Wandlerverstärkung auf, um die Eingangs-Sensorantwort SA₁ in den Eingangs-Messwert y₁ zu wandeln, erweist es sich in vielfach als effiziente Umsetzungsvariante der Erfindung, die Wandlerverstärkung zur Korrektur der Eingangs-Wandlungseinheit W₁ zu vergrößern oder zu verkleinern. Um die Vergrößerung oder Verkleinerung zu ermitteln, kann beispielsweise ein Skalierungsfaktor vorgegeben werden, der den Kalibrier-Vergleichswert e_{y} auf einen Vergrößerungswert zum Vergrößern oder Verkleinern der Eingangs-Wandlungseinheit W₁ abbildet. Grundsätzlich ist es im Fall alternativ aufgebauter oder komplexerer Wandlungseinheiten jedoch auch möglich, an anderen Stellen anzusetzen, um eine erfindungsgemäße Korrektur vornehmen zu können. Beispielsweise ist ebenso denkbar, eine Taktfrequenz einer digital umgesetzten Wandlungseinheit anzupassen, oder eine Totzeit einer Wandlungseinheit zu verändern. In diesem Punkt bietet die Erfindung große Flexibilität.

Ferner kann die erfindungsgemäße Vorgehensweise leicht an mehreren Stellen ergänzt und vorteilhaft erweitert werden. Beispielsweise ist es möglich, den Kalibrier-Vergleichswert e_{y} zur Durchführung einer Plausibilitätsprüfung mit einem vorgegebenen Plausibilitätswert zu vergleichen und, wenn der Kalibrier-Vergleichswert e_{y} den Plausibilitätswert überschreitet oder unterschreitet, eine Sicherungs-Aktion auszulösen. Bei einer Sicherungs-Aktion kann es sich beispielsweise um die Ausgabe eines Warnsignals handeln, die einem Benutzer mitteilt, dass einer der vorhandenen Sensoren defekt ist, oder es kann das technische System deaktiviert werden oder in einen Sicherheitsmodus überführt werden.

Wie ebenso anhand von Fig.2 erkennbar ist, können sämtliche im Rahmen des erfindungsgemäßen Verfahrens auftretenden Signale gefiltert werden. Mitunter ist dies auch notwendig, um verschiedene Messsignale miteinander vergleichbar zu machen, z.B. Gleichspannungen mit Wechselspannungen, wozu mittels einer geeigneten Filterung insbesondere ein Scheitelwert einer Wechselspannung ermittelt und mit einer Gleichspannung verglichen werden kann. Konkret kann zum Zweck einer Filterung im Kalibrier-Abschnitt ein Eingangs-Messverlauf yt1 umfassend eine Vielzahl von Eingangs-Messwerten y_{1,k}, y_{1,k+1}, y_{1,k+2}, ... und ein Ausgangs-Messverlauf yt2 umfassend eine Vielzahl von Ausgangs-Messwerten y_{2,k}, y_{2,k+1}, y_{2,k+2}, ... erfasst werden (der Index k steht wie in der digitalen Signalverarbeitung üblich für einen zeitlichen Index zur Beschreibung ganzzahlig Vielfacher einer Abtastzeit T_{d}, d.h. tₖ = k*T_{d}) und es können die gesamten Verläufe oder zumindest Teile der Verläufe miteinander verglichen werden, d.h. eine Vielzahl an Ein- und Ausgangs-Messwerten miteinander verglichen werden, um den Kalibrier-Vergleichswert e_{y} zu generieren. Um solche zeitlichen Verläufe zu filtern, können ein Eingangs-Messfilter F1 und/oder ein Ausgangs-Messfilter F2 und/oder ein Vergleichs-Messfilter F3 zum Filtern des Kalibrier-Vergleichswertes e_{y} vorgesehen werden, bevorzugt in Form eines Tiefpassfilters oder in Form eines Hochpassfilters oder in Form eines Bandpassfilters oder in Form eines Mittelwertfilters oder in Form eines Maximumfilters oder in Form eines Minimumfilters oder in Form einer Absolutwertbildung oder in Form eines Skalierungsfaktors oder in Form einer Kombination der vorgenannten Filter realisiert ist. Im vorhin angesprochenen Fall des Vergleichs einer Wechselspannung mit einer Gleichspannung kann ein Eingangs-Messfilter F1 beispielsweise auch ein nichtlineares Filter sein, das zunächst einen Absolutwert bildet und anschließend je Periode einen maximalen Scheitelwert ermittelt, der mit einer am Ausgang gemessenen Gleichspannung verglichen wird. Ein Vergleichs-Messfilter F3 kann insbesondere einen geeigneten Skalierungsfaktor enthalten, um den Kalibrier-Vergleichswert e_{y} auf ein geeignetes Signal zum Kalibrieren der Wandlungseinheiten umzurechnen.

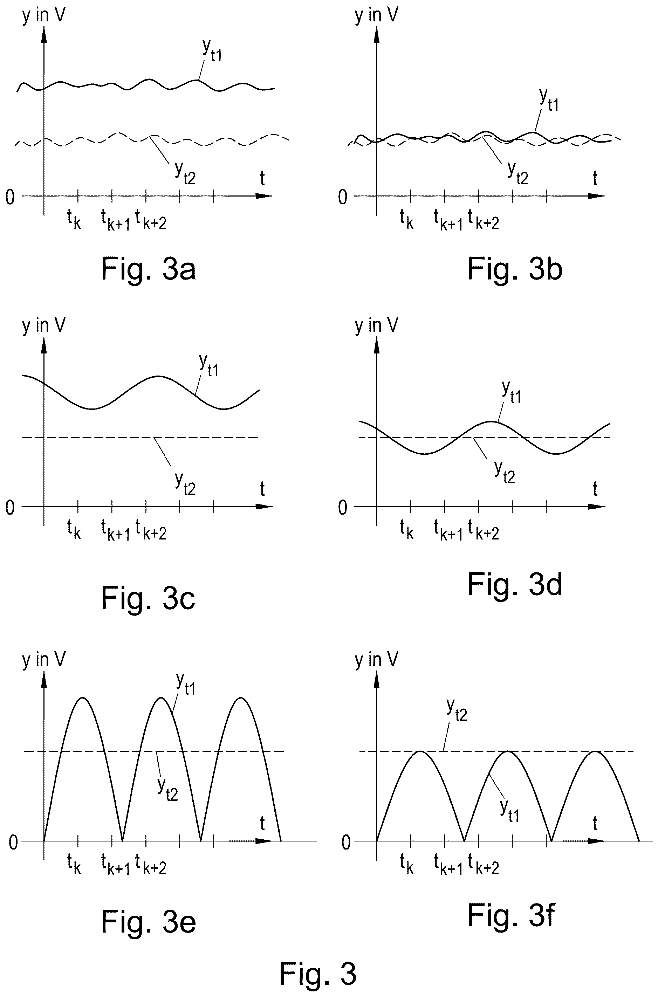

Mögliche zeitliche Verläufe eines Eingangs-Messwertes y₁ und eines Ausgangs-Messwertes y₂ sind in Fig.3 gezeigt. Die Figuren 3a (nicht kalibriert) und 3b (kalibriert) zeigen hierbei zwei in ihrem Mittel konstante Zeitverläufe eines Eingangs-Messwertes y₁ und eines Ausgangs-Messwertes y₂, die vor der erfindungsgemäßen Kalibrierung nebeneinander (d.h. entlang der vertikalen y-Achse verschoben) und nach der erfindungsgemäßen Kalibrierung übereinander liegen. Die Figuren 3c (nicht kalibriert) und 3d (kalibriert) zeigen ferner den für die Praxis wichtigen Fall einer eingangsseitigen Wechselgröße, z.B. einer Wechselspannung mit Offset, und einer ausgangsseitigen Gleichgröße, die z.B. bloß dem Offset entsprechen kann. Durch die Kalibrierung wird hier sichergestellt, dass ausgangsseitige Gleichgröße und Offset der Eingangsgröße übereinstimmen. Die Figuren 3e (nicht kalibriert) und 3f (kalibriert) zeigen darüber hinaus den insbesondere für eine Anwendung der Erfindung bei einem Gleichrichter 2 wichtigen Fall eines Vergleichs von Scheitelwerten y1 mit einer Gleichgrößen y2. Durch Reduktion einer Messverstärkung können im Fall der Figuren 3e und 3f die Scheitelwerte y1 auf die Gleichgröße y2 abgestimmt werden.

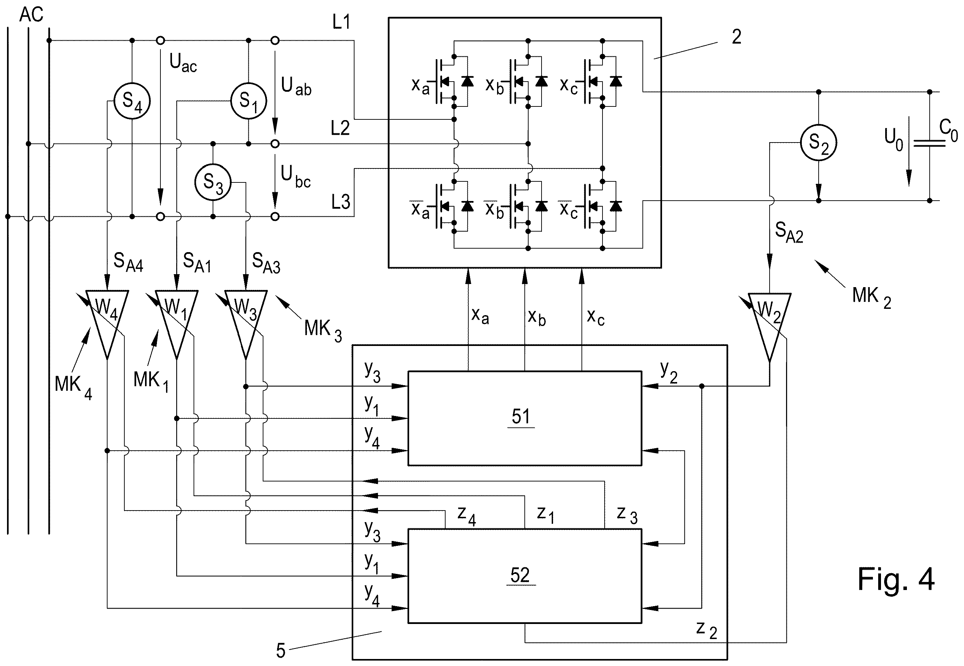

Wie erwähnt, ist es möglich, die Erfindung in einer besonders vorteilhaften Weise zum Betrieb eines Netzgleichrichters 2 einzusetzen. Sämtliche der vorstehenden Überlegungen können demnach auf einen Netzgleichrichter 2, wie er bereits in Fig.1 gezeigt wurde, übertragen werden, wie nachfolgend anhand von Fig.4 erläutert wird.

Konkret zeigt Fig.4 hierbei eine besonders vorteilhafte Anwendung des erfindungsgemäßen Verfahrens, wobei ein schaltbarer Netzgleichrichter 2 aufweisend schaltbare Halbleiterschalter Tₐ₁, Tₐ₂, ... als technisches System 2 vorgesehen ist. Als Kalibrier-Zustand wird ein Zustand des Netzgleichrichters 2 vorgesehen, in welchem die im Netzgleichrichter 2 vorliegenden Halbleiterschalter Tₐ₁, Tₐ₂, ... geöffnet sind und nicht geschaltet werden. Besonders bevorzugt kann als zeitlicher Kalibrier-Abschnitt ein Zeitabschnitt gewählt werden, in welchem der Zwischenkreiskondensator C₀ geladen ist und insbesondere noch nicht belastet wird. Als Aktiv-Zustand kann insbesondere ein Zustand des Netzgleichrichters 2 vorgesehen werden, in welchem die im Netzgleichrichter 2 vorliegenden Halbleiterschalter Tₐ₁, Tₐ₂, ... geschaltet werden, um eine vom Netzgleichrichter 2 ausgegebene DC- Zwischenkreisspannung U₀ auf einen vorgegebenen Zwischenkreisspannungs-Sollwert einzuregeln. Im Aktiv-Zustand wird der Zwischenkreiskondensator C₀ also belastet, das heißt insbesondere es wird dem Zwischenkreiskondensator C₀ elektrische Ladung hin zur Last 4 entnommen und es wird neue elektrische Ladung nachgeliefert, im Gegensatz zum Kalibrier-Abschnitt, in dem bevorzugt keine Belastung stattfindet.

Kalibrier-Abschnitte stellen sich im Fall des in Fig.4 gezeigten Netzgleichrichters 2 insbesondere ein, nachdem AC-seitige Schütze (nicht gezeigt) zum Verbinden und Trennen des Netzgleichrichter 2 an das AC-Netz geschlossen worden sind, um eine Verbindung zwischen Netzgleichrichter 2 und AC-Netz herzustellen, die Halbleiterschalter Tₐ₁, Tₐ₂, ... im Netzgleichrichter 2 aber noch nicht aktiv geschaltet werden, sodass es lediglich zu einer passiven Aufladung des Zwischenkreiskondensators C₀ über die Freilaufdioden im Netzgleichrichter 2 kommt (der Netzgleichrichter 2 ist passiv), die passive Aufladung des Zwischenkreiskondensator C₀ ferner bereits abgeschlossen ist, der Zwischenkreis jedoch noch unbelastet ist. Um zu überprüfen, ob der Zwischenkreiskondensator C₀ aufgeladen ist, kann überprüft werden, ob ein entsprechender Ladevorgang abgeschlossen ist. Zu diesem Zweck kann beispielswiese überwacht werden, ob die am Zwischenkreiskondensator C₀ abfallende DC-Zwischenkreisspannung U₀ konstant bleibt, d.h. z.B. in der Praxis, dass die am Zwischenkreiskondensator C₀ abfallende DC-Zwischenkreisspannung U₀ um weniger als eine vorgegebene Änderungsschwelle schwankt, z.B. um weniger als 10V oder um weniger 5V oder weniger als 1V oder weniger als 0,1V. Denkbar wäre hierzu auch eine Überwachung der jeweils in den einzelnen Phasen des Netzgleichrichters 2 auftretenden Stromflüsse (ist die DC-Zwischenkreisspannung U₀ konstant und der Zwischenkreiskondensator C₀ geladen, verschwinden diese Ströme im Idealfall, oder werden in der Praxis zumindest sehr gering). Schwankungen der Zwischenkreisspannung U₀ oder kurzfristig hohe Werte, welche aufgrund eines vorigen aktiven Betriebs des Gleichrichters 2 noch nicht wieder auf das Niveau der passiven Spannung abgesunken ist, können so erkannt werden. Es wird folglich die Spannungsstabilität der DC-Zwischenkreisspannung U₀ überwacht. Damit einhergehenden Problemen kann durch Abwarten und erneuten Beginn der Messung/Kalibrierung (automatisiert) entgegnet werden.

Wie in Fig.4 gezeigt, können in der Steuereinheit 5 zur Umsetzung der Erfindung zwei Subeinheiten 51, 52 vorgesehen werden. In der ersten Subeinheit 51 können, wie angedeutet, die Schaltsignale xₐ, x_{b}, x_{c} zum Schalten der Halbleiterschalter Tₐ₁, Tₐ₂, ... ermittelt werden, insbesondere mithilfe eines in der ersten Subeinheit 51 implementierten Reglers. In der zweiten Subeinheit 52 kann die erfindungsgemäße Korrektur der Eingangs-Wandlungseinheit W₁ vorgenommen werden. Wie in Fig.4 gezeigt, kann die zweite Subeinheit 52 zu diesem Zweck die Korrektursignale z₁, z₂, z₃ ermitteln. Bei den Korrektursignalen z₁, z₂, z₃ kann es sich um multiplikative Korrektursignale z₁, z₂, z₃ handeln, die insbesondere eine Wandler-Verstärkung skalieren, oder es kann sich um additive Korrektursignale z₁, z₂, z₃ handeln, die z.B. zu einer Wandler-Verstärkung addiert werden, oder es kann auch überhaupt eine neue Wandler-Verstärkung ermittelt werden, die ein alte Wandler-Verstärkung ersetzt. Wie ebenso in Fig.4 angedeutet, können die genannten Subeinheiten 51, 52 natürlich miteinander kommunizieren, sodass beispielsweise die zweite Subeinheit 52 der ersten Subeinheit 51 mitteilen kann, dass gerade ein Kalibriervorgang erfolgt, und dass noch nicht mit einem aktiven Schalten begonnen werden soll.

Um eine neue Wandler-Verstärkung zu ermitteln, kann z.B. die Rechenvorschrift 2*U₀ / U_{SS} angesetzt werden, mit U_{SS}/2 als halbem Spitze-Spitze-Wert der AC-Wechselspannung bei seiner Grundschwingungskomponente (Europa: 50Hz, USA: 60Hz). Für den Fall, dass U_{SS}/2 größer ist als U₀, ergibt sich eine Wandler-Verstärkung von <1.0 welche anschließend verwendet werden kann, um die netzseitigen, verketteten Spannungen beim Messen entsprechend kleiner zu skalieren. Im umgekehrten Fall würde sich eine Wandler-Verstärkung von >1.0 ergeben. Die Freilaufdioden, welche in der passiven Gleichrichtung vorhanden sind, werden in dieser konkreten Berechnung in einer vorteilhaften und vereinfachenden Weise vernachlässigt, da der dadurch eingebrachte Fehler ebenfalls als vernachlässigbar angesehen werden kann. Diese würden bei Berücksichtigung den passiven Gleichrichtwert um 2 Diodenvorwärtsspannungen verkleinern.

Umgelegt auf eine Fig.4 entsprechende Situation kann die Idee der Erfindung demnach wie folgt zusammengefasst werden. Es wird die DC-Zwischenkreisspannung nach der passiven Gleichrichtung über die Dioden genutzt, um einen Referenzwert für den Scheitelwert der AC-Spannung bereitzustellen. Es wird sowohl die passive DC-Gleichrichtspannung als auch der Scheitelwert beider verketteten Spannungen gemittelt, anschließend ein Fehler berechnet und letztlich die Messverstärkung um diesen Fehler korrigiert.

## Patentansprüche

1. Verfahren zur Ermittlung eines Messwertes (y₁, y₂), wobei vorgesehen werden
- ein Eingangs-Sensor (S₁) zum messtechnischen Erfassen einer Eingangsgröße (u₁) eines technischen Systems (2) sowie zum Ausgeben einer Eingangs-Sensorantwort (SA₁) in Abhängigkeit der Eingangsgröße (u₁),
- eine Eingangs-Wandlungseinheit (W₁) zum Wandeln der Eingangs-Sensorantwort (SA₁) in einen Eingangs-Messwert (y₁),
- ein Ausgangs-Sensor (S₂) zum messtechnischen Erfassen einer Ausgangsgröße (u₂) des technischen Systems (2) sowie zum Ausgeben einer Ausgangs-Sensorantwort (SA₂) in Abhängigkeit der Ausgangsgröße (u₂),
- eine Ausgangs-Wandlungseinheit (W₂) zum Wandeln der Ausgangs-Sensorantwort (SA₂) in einen Ausgangs-Messwert (y₂),
**dadurch gekennzeichnet, dass** in einem zeitlichen Kalibrier-Abschnitt, in dem sich das technische System (2) in einem Kalibrier-Zustand befindet, ein Eingangs-Messwert (y₁) und ein Ausgangs-Messwert (y₂) erfasst und miteinander verglichen werden, um einen Kalibrier-Vergleichswert (e_{y}) zu generieren, **dass** die Eingangs-Wandlungseinheit (W₁) in Abhängigkeit des Kalibrier-Vergleichswertes (e_{y}) zu einer korrigierten Eingangs-Wandlungseinheit (W₁) korrigiert wird und/oder die Ausgangs-Wandlungseinheit (W₂) in Abhängigkeit des Kalibrier-Vergleichswertes (e_{y}) zu einer korrigierten Ausgangs-Wandlungseinheit (W₂) korrigiert wird, **und dass** in einem zeitlichen Aktiv-Abschnitt, in dem sich das technische System (2) in einem vom Kalibrier-Zustand verschiedenen Aktiv-Zustand befindet, die korrigierte Eingangs-Wandlungseinheit (W₁) dazu herangezogen wird, um die Eingangsgröße (u₁) zu messen, und/oder die korrigierte Ausgangs-Wandlungseinheit (W₂) dazu herangezogen wird, um die Ausgangsgröße (u₂) zu messen.

2. Verfahren nach Anspruch 1, **dadurch gekennzeichnet, dass** die Eingangs-Wandlungseinheit (W₁) eine Wandlerverstärkung aufweist, um die Eingangs-Sensorantwort (SA₁) in den Eingangs-Messwert (y₁) zu wandeln und/oder die Ausgangs-Wandlungseinheit (W₂) eine Wandlerverstärkung aufweist, um die Ausgangs-Sensorantwort (SA₂) in einen Ausgangs-Messwert (y₂) zu wandeln, **und dass** die Wandlerverstärkung zur Korrektur in Abhängigkeit des Kalibrier-Vergleichswertes (e_{y}) vergrößert oder verkleinert wird.

3. Verfahren nach einem der vorhergehenden Ansprüche, **dadurch gekennzeichnet, dass** die Eingangsgröße (u₁) gemäß einem durch einen Zustand des technischen Systems (2) festgelegten Übertragungsverhältnis des technischen Systems (2) mit der Ausgangsgröße (u₂) zusammenhängt, wobei das Übertragungsverhältnis im Kalibrier-Abschnitt einem vorgegebenen, gleichbleibenden Übertragungsverhältnis entspricht und im Aktiv-Abschnitt einem veränderlichen Übertragungsverhältnis entspricht.

4. Verfahren nach einem der vorhergehenden Ansprüche, **dadurch gekennzeichnet, dass** im Kalibrier-Abschnitt ein Eingangs-Messverlauf (yt1) umfassend eine Vielzahl von Eingangs-Messwerten (y_{1,k}, y_{1,k+1}, y_{1,k+2}, ...) und ein Ausgangs-Messverlauf (yt2) umfassend eine Vielzahl von Ausgangs-Messwerten (y_{2,k}, y_{2,k+1}, y_{2,k+2}, ...) erfasst und miteinander verglichen werden, um den Kalibrier-Vergleichswert (e_{y}) zu generieren.

5. Verfahren nach Anspruch 4, **dadurch gekennzeichnet, dass** der Eingangs-Messverlauf (yt1) vor dem Vergleich mit dem Ausgangs-Messverlauf (yt2) mittels eines Eingangs-Messfilters (F1) gefiltert wird **und/oder dass** der Ausgangs-Messverlauf (yt2) vor dem Vergleich mit dem Eingangs-Messverlauf (yt2) mittels eines Ausgangs-Messfilters (F2) gefiltert wird **und/oder dass** ein zeitlicher Verlauf von Kalibrier-Vergleichswerten (e_{y}) vor einer Verwendung zur Korrektur der Eingangs-Wandlungseinheit (W₁) mittels eines Vergleichs-Filters (F3) gefiltert wird.

6. Verfahren nach Anspruch 5, **dadurch gekennzeichnet, dass** das Eingangs-Messfilters (F1) und/oder das Ausgangs-Messfilter (F2) und/oder das Vergleichs-Filter (F3) in Form eines Tiefpassfilters oder in Form eines Hochpassfilters oder in Form eines Bandpassfilters oder in Form eines Mittelwertfilters oder in Form eines Maximumfilters oder in Form eines Minimumfilters oder in Form einer Absolutwertbildung oder in Form eines Skalierungsfaktors oder in Form einer Kombination der vorgenannten Filter realisiert ist.

7. Verfahren nach einem der vorhergehenden Ansprüche, **dadurch gekennzeichnet, dass** der Kalibrier-Vergleichswert (e_{y}) zur Durchführung einer Plausibilitätsprüfung mit einem vorgegebenen Plausibilitätswert verglichen wird **und dass,** wenn der Kalibrier-Vergleichswert (e_{y}) den Plausibilitätswert überschreitet oder unterschreitet, eine Sicherungs-Aktion ausgelöst wird.

8. Verfahren nach einem der vorhergehenden Ansprüche, **dadurch gekennzeichnet, dass** ein schaltbarer Netzgleichrichter (2) als technisches System (2) vorgesehen wird mit einer netzseitigen AC-Spannung als Eingangsgröße (u₁) und einer DC- Zwischenkreisspannung als Ausgangsgröße (u₂) **oder dass** ein Elektromotor als technisches System (2) vorgesehen wird mit einem AC-Phasenstrom als Eingangsgröße (u₁) und einem vom Elektromotor erzeugten Drehmoment als Ausgangsgröße (u₂) **oder dass** ein Verbrennungsmotor als technisches System (2) vorgesehen wird mit einer Gaspedalstellung als Eingangsgröße (u₁) und einem Kurbelwellendrehmoment als Ausgangsgröße (u₂) **oder dass** ein Antriebsstrangprüfstand als technisches System (2) vorgesehen wird mit einem Belastungsdrehmoment als Eingangsgröße (u₁) und einer Prüflingsdrehzahl als Ausgangsgröße (u₂).

9. Verfahren nach Anspruch 8, **dadurch gekennzeichnet, dass** ein schaltbarer Netzgleichrichter (2) aufweisend schaltbare Halbleiterschalter (Tₐ₁, Tₐ₂, ...) als technisches System (2) vorgesehen wird, wobei als Kalibrier-Zustand ein Zustand des Netzgleichrichters (2) vorgesehen wird, in welchem die im Netzgleichrichter (2) vorliegenden Halbleiterschalter (Tₐ₁, Tₐ₂, ...) geöffnet sind und nicht geschaltet werden und wobei als Aktiv-Zustand ein Zustand des Netzgleichrichters (2) vorgesehen wird, in welchem die im Netzgleichrichter (2) vorliegenden Halbleiterschalter geschaltet werden, um eine vom Netzgleichrichter (2) ausgegebene DC- Zwischenkreisspannung auf einen vorgegebenen Zwischenkreisspannungs-Sollwert einzuregeln.

10. Verfahren nach Anspruch 9, **dadurch gekennzeichnet, dass** am Ausgang des schaltbaren Netzgleichrichters (2) ein Zwischenkreiskondensator (C₀) vorgesehen wird, an dem die DC-Zwischenkreisspannung abfällt, **und dass** als zeitlicher Kalibrier-Abschnitt ein Zeitabschnitt gewählt wird, in welchem der Zwischenkreiskondensator (C0) geladen ist und vorzugsweise nicht belastet wird.

11. Verfahren nach einem der Ansprüche 8 bis 10, **dadurch gekennzeichnet, dass** ein schaltbarer Netzgleichrichter (2) als technisches System (2) vorgesehen wird und der schaltbare Netzgleichrichter (2) als Teil eines Batterieemulators (1) oder als Teil eines Batterietesters vorgesehen wird, wobei der Netzgleichrichter (2) auf einer Eingangsseite des Netzgleichrichters (2) mit einem AC-Versorgungsnetz, das eine netzseitige AC-Spannung für den Netzgleichrichter (2) bereitstellt, verbunden wird und auf einer Ausgangsseite des Netzgleichrichters (2) mit einem Zwischenkreiskondensator (C₀) zur Stabilisierung einer vom Netzgleichrichter (2) ausgegebenen DC-Zwischenkreisspannung (U₀) verbunden wird, wobei der Zwischenkreiskondensator (C₀) weiters mit einem Gleichspannungswandler (3) verbunden wird, um die DC-Zwischenkreisspannung (U₀) in eine Ausgangsspannung (u_{A}) zu wandeln.

12. Verfahren nach Anspruch 11, **dadurch gekennzeichnet, dass** ein PI-Regler oder ein PID-Regler oder ein Sliding-Mode-Regler oder Backstepping-Regler oder eine modellbasierte Regelung mit einem Modell des Netzgleichrichters (2) zur Regelung des Netzgleichrichters (2) verwendet wird, wobei Messwerte der netzseitigen AC-Spannung als Eingangs-Messwert (y₁) und Messwerte der DC-Zwischenkreisspannung (U₀) als Ausgangs-Messwert (y₂) in der Regelung verwendet werden.

13. Kalibrier-Vorrichtung zur Kalibrierung einer Eingangs-Wandlungseinheit (W₁) und/oder einer Ausgangs-Wandlungseinheit (W₂), wobei die Kalibrier-Vorrichtung ausgestaltet ist, einen Eingangs-Messwert (y₁) und einen Ausgangs-Messwert (y₂) miteinander zu vergleichen, um einen Kalibrier-Vergleichswert (e_{y}) zu generieren und die Eingangs-Wandlungseinheit (W₁) in Abhängigkeit des Kalibrier-Vergleichswertes (e_{y}) zu einer korrigierten Eingangs-Wandlungseinheit (W₁) zu korrigieren und/oder die Ausgangs-Wandlungseinheit (W₂) in Abhängigkeit des Kalibrier-Vergleichswertes (e_{y}) zu einer korrigierten Ausgangs-Wandlungseinheit (W₂) zu korrigieren, wobei
- der Eingangs-Messwert (y₁) erzeugbar ist, indem ein Eingangs-Sensor (S₁) eine Eingangsgröße (u₁) eines technischen Systems (2), welches sich in einem Kalibrier-Zustand befindet, messtechnisch erfasst und eine Eingangs-Sensorantwort (SA₁) in Abhängigkeit der Eingangsgröße (u₁) ausgibt und die Eingangs-Wandlungseinheit (W₁) die Eingangs-Sensorantwort (SA₁) in den Eingangs-Messwert (y₁) wandelt,
- der Ausgangs-Messwert (y₂) erzeugbar ist, indem ein Ausgangs-Sensor (S₂) eine Ausgangsgröße (u₂) des sich im Kalibrier-Zustand befindenden technischen Systems (2) messtechnisch erfasst und eine Ausgangs-Sensorantwort (SA₂) in Abhängigkeit der Ausgangsgröße (u₂) ausgibt und die Ausgangs-Wandlungseinheit (W₂) die Ausgangs-Sensorantwort (SA₂) in den Ausgangs-Messwert (y₂) wandelt.

14. Mess-Vorrichtung zur Ermittlung eines Messwertes (y₁, y₂), aufweisend
- einen Eingangs-Sensor (S₁) zum messtechnischen Erfassen einer Eingangsgröße (u₁) eines technischen Systems (2) sowie zum Ausgeben einer Eingangs-Sensorantwort (SA₁) in Abhängigkeit der Eingangsgröße (u₁),
- eine Eingangs-Wandlungseinheit (W₁) zum Wandeln der Eingangs-Sensorantwort (SA₁) in einen Eingangs-Messwert (y₁),
- einen Ausgangs-Sensor (S₂) zum messtechnischen Erfassen einer Ausgangsgröße (u₂) des technischen Systems (2) sowie zum Ausgeben einer Ausgangs-Sensorantwort (SA₂) in Abhängigkeit der Ausgangsgröße (u₂),
- eine Ausgangs-Wandlungseinheit (W₂) zum Wandeln der Ausgangs-Sensorantwort (SA₂) in einen Ausgangs-Messwert (y₂),
- eine Kalibrier-Vorrichtung nach Anspruch 13, welche ausgestaltet ist, einen Eingangs-Messwert (y₁) und einen Ausgangs-Messwert (y₂), die in einem zeitlichen Kalibrier-Abschnitt, in dem sich das technische System (2) in einem Kalibrier-Zustand befindet, erfasst werden, einzulesen und miteinander zu vergleichen, um einen Kalibrier-Vergleichswert (e_{y}) zu generieren, und die Eingangs-Wandlungseinheit (W₁) in Abhängigkeit des Kalibrier-Vergleichswertes (e_{y}) zu einer korrigierten Eingangs-Wandlungseinheit (W₁) zu korrigieren und/oder die Ausgangs-Wandlungseinheit (W₂) in Abhängigkeit des Kalibrier-Vergleichswertes (e_{y}) zu einer korrigierten Ausgangs-Wandlungseinheit (W₂) zu korrigieren, um in einem zeitlichen Aktiv-Abschnitt, in dem sich das technische System (2) in einem vom Kalibrier-Zustand verschiedenen Aktiv-Zustand befindet, die Eingangsgröße (u₁) mittels der korrigierten Eingangs-Wandlungseinheit (W₁) und/oder die Ausgangsgröße (u₂) mittels der korrigierten Ausgangs-Wandlungseinheit (W₁) zu messen.

15. Mess-Vorrichtung nach Anspruch 14, wobei ein Netzgleichrichter (2) als technisches System (2) vorgesehen ist.
